# EUROPEAN PATENT APPLICATION

(11) **EP 4 608 080 A1**
(43) Date of publication of application: **27.08.2025**
(21) Application number: 25159381.0
(22) Date of filing: 21.02.2025
(51) Int. Cl.: H05K 7/14, G01D 11/24

(54) **EXPLOSION-RESISTANT DEVICES AND COVER ASSEMBLIES FOR A HAZARDOUS ENVIRONMENT**

(30) Priority: 21.02.2024 US 202418583559
(71) Applicant: ABB SCHWEIZ AG, 5400 Baden (CH)
(72) Inventor: Robertson, Brian, 5400 Baden (CH); May, Michael, 5400 Baden (CH)
(74) Representative: Zimmermann & Partner Patentanwälte mbB

(57) **Abstract**

An explosion-resistant device for a hazardous environment is provided. The device includes an enclosure. The enclosure includes a body, a projected rim extending away from the body and defining an opening, and rim threads positioned on a surface of the projected rim. The device further includes a cover assembly including a joint that includes a first portion and a second portion, the first portion affixed with the body. The cover assembly further includes a cap including a cap top and a cap side extending from the cap top, the cap side further including cap threads complementary to the rim threads. The cover assembly also includes a radial support affixed with the second portion and obstructing the cap from dislocating out of the radial support. The cover assembly is rotatably coupled with the enclosure via the joint.

## Description

### BACKGROUND

The field of the disclosure relates generally to explosion management, and more particularly, to explosion-resistant devices and cover assemblies.

Field devices, such as sensors, analyzers, and interfaces, are used in various industrial devices, systems, and/or methods. In environments in which explosive substances, such as alcohols and/or petroleum products, are present or may potentially be present, (e.g., a hazardous environment) hazards of igniting the explosive substance via electronic equipment within the field devices may exist. Some field devices may be involved with explosive substances, such as sensors for a production process, where the explosive substances are within the precursor, intermediate product, incidental product, and/or final product. Additionally, the environment for such devices may contain explosive substances, for example, gases, which could be ignited by the electronic equipment of the devices and/or by an explosion originating from within the devices.

Known explosion management systems and methods are disadvantaged in some aspects, and improvements are desired.

### BRIEF DESCRIPTION

In one aspect, an explosion-resistant device for a hazardous environment is provided. The explosion-resistant device includes an enclosure sized to enclose equipment therein and including a body. The enclosure further includes a projected rim extending away from the body and defining an opening, the opening providing an access to the equipment. The enclosure also includes rim threads positioned on a surface of the projected rim. The explosion-resistant device further includes a cover assembly including a joint that includes a first portion and a second portion, the first portion affixed with the body. The cover assembly further includes a cap including a cap top and a cap side extending from the cap top, the cap side further including cap threads complementary to the rim threads. The cover assembly also includes a radial support affixed with the second portion and obstructing the cap from dislocating out of the radial support. The cover assembly is rotatably coupled with the enclosure via the joint.

**In** another aspect, a cover assembly of an explosion-resistant device for a hazardous environment is provided. The cover assembly includes a joint including a first portion and a second portion, the first portion configured to be affixed with an enclosure of an explosion-resistant device. The cover assembly also includes a radial support affixed with the second portion. The cover assembly further includes a cap including a cap top and a cap side extending from the cap top. The radial support includes a support projection projecting from an interior surface of the radial support, the cap side further including a side projection positioned adjacent to an end of the cap side opposite from the cap top, the side projection projecting from an exterior surface of the cap side, the support projection positioned between the cap top and the side projection and obstructing the cap from dislocating out of the radial support. The cover assembly is configured to rotatably couple with the enclosure via the joint.

In one more aspect, a method of assembling an explosion-resistant device for a hazardous environment is provided. The method includes forming a cover assembly. The cover assembly includes a joint including a first portion and a second portion. The cover assembly further includes a cap including a cap top, and a cap side extending from the cap top, the cap side further including cap threads. The cover assembly also includes a radial support affixed with the second portion of the joint and obstructing the cap from dislocating out of the radial support. The method further includes affixing the cover assembly with an enclosure of an explosion-resistant device, the enclosure sized to contain equipment therein and including a body. The enclosure further includes a projected rim extending away from the body and defining an opening providing an access to the equipment, and rim threads positioned on a surface of the projected rim and complementary to the cap threads. Affixing the cover assembly further includes affixing the first portion of the joint with the body.

### BRIEF DESCRIPTION OF DRAWINGS

These and other features, aspects, and advantages of the present disclosure will become better understood when the following detailed description is read with reference to the accompanying drawings in which like characters represent like parts throughout the drawings.
FIG. 1A is a left perspective view of an example explosion-resistant device.
FIG. 1B is a right perspective view of the explosion-resistant device shown in FIG. 1A.
FIG. 1C is a perspective view of the explosion-resistant device shown in FIG. 1A with its cover assembly open.
FIG. 1D is an enlarged view of a portion of the explosion-resistant device shown in FIG. 1A, where the portion is indicated as 1D in FIG. 1A.
FIG. 1E is a right perspective view of the portion shown in FIG. 1D.
FIG. 2A is a left perspective view of an example cover assembly of the explosion-resistant device shown in FIG. 1A.
FIG. 2B is a right perspective view of the cover assembly shown in FIG. 2A.
FIG. 2C is a perspective view of a latch pin and a loop in an example latch of the cover assembly shown in FIG. 2A.
FIG. 3A is a front perspective view of a first joint portion in an example joint of the cover assembly shown in FIG. 2A.
FIG. 3B is a rear perspective view of the first joint portion shown in FIG. 3A.
FIG. 3C is a perspective view of a joint pin in the joint of the cover assembly shown in FIG. 2A.
FIG. 3D shows an example radial support of the cover assembly shown in FIG. 2A.
FIG. 3E is a right perspective view of the radial support shown in FIG. 3D.
FIG. 4A is a rear perspective view of an example cap of the cover assembly shown in FIG. 2A.
FIG. 4B is a right perspective view of the cap shown in FIG. 4A.
FIG. 5A is a side perspective view of the cover assembly shown in FIG. 2A with a segment of the radial support removed.
FIG. 5B is a cross-sectional view of the explosion-resistant device shown in FIG. 1B along cross-sectional line 5B-5B as marked in FIG. 1B.
FIG. 5C is an enlarged view of a portion of the explosion-resistant device shown in FIG. 5B, where the portion is indicated as 5C in FIG. 5B.
FIG. 6A is a cross-sectional view of a portion of the explosion-resistant device along cross-sectional line 6A-6A as marked in FIG. 1A, when the cap is threaded to the projected rim in the enclosure of the explosion-resistant device.
FIG. 6B shows the explosion-resistant device when the cap is unthreaded from the projected rim.
FIG. 6C shows the explosion-resistant device when the cover assembly is open.
FIG. 7 is a flow chart of an example method of assembling an explosion-resistant device as described in FIGs. 1A-6C.

### DETAILED DESCRIPTION

The disclosure includes explosion-resistant devices and cover assemblies for a hazardous environment. As used herein, an explosion-resistant device is configured to be used in an environment, where explosive substances are or may be present, and is configured to be compliant with standards stipulated for such an environment. Within the present disclosure, the resistance to explosion and/or flammability risks, including from electronic instrumentation, is described as explosion resistance. Method aspects will be in part apparent and in part explicitly discussed in the following description.

Electronic instrumentation (e.g., electronic measurement instruments and displays) may assist in high quality, safe, and/or efficient process management. In environments in which explosive and/or flammable substances may be present (e.g., in a hazardous environment), electronic instrumentation may pose an explosion risk. In particular, when using electronic instrumentation to conduct field analyses of process substances with flammability and/or explosion risks, the electronic instrumentation may pose a risk of ignition. For example, flammable and/or explosive gases to be analyzed by electronic instrumentation may be ignited if the flammable and/or explosive gases come into contact with components of the electronic instrumentation.

A device that operates within hazardous environments presents a risk of explosion via ignition of a surrounding gas or vapor dusts, fibers, or flyings. Such hazardous environments may arise, for example only, in petroleum refineries, petrochemical plants, grain silos, wastewater, and/or treatment facilities among other industrial facilities, where volatile conditions are produced in the ambient environment and present a heightened risk of fire or explosion. An occasional or continuous presence of airborne ignitable gas, ignitable vapors or dust, or otherwise flammable substances presents substantial concerns regarding safe and reliable operation of such facilities overall, including, but not limited to, safe operation of the device such as containing sparks within the device to prevent possible fire or explosion. As such, a number of standards have been promulgated relating to electrical products used in explosive environments to improve safety in hazardous locations in view of an assessed probability of explosion or fire risk.

For example, Underwriter's Laboratories ("UL") standard UL 1203 sets forth Explosion-Proof and Dust-Ignition-Proof Electrical Equipment criteria for hazardous locations. Electrical equipment manufacturers may receive UL certification of compliance with the applicable rating standards for hazardous locations, and UL certification is an important aspect of a manufacturer's ability to successfully bring products to market in North America or any other market accepting UL standard 1203.

The National Electric Code (NEC) generally classifies hazardous locations by class and division. Class I locations are those in which flammable vapors and gases may be present. Class II locations are those in which combustible dust may be found. Class III locations are those which are hazardous because of the presence of easily ignitable fibers or flyings. Class I, Division 1 covers locations where flammable gases or vapors may exist under normal operating conditions or under frequent repair or maintenance operations, or where breakdown or faulty operation of process equipment might also cause simultaneous failure of electrical equipment. Division 1 presents a greater risk of explosion than, for example, Division 2 where flammable gases or vapors are normally handled either in a closed system, confined within suitable enclosures, or are normally prevented by positive mechanical ventilation.

The International Electrotechnical Commission (IEC) likewise categorizes hazardous locations into Class I, Zone 0, 1, or 2 representing locations in which flammable gases or vapors are or may be airborne in an amount sufficient to produce explosive or ignitable mixtures. As defined by the IEC, a Class I, Zone 0 location is a location in which ignitable concentrations of flammable gases or vapors are present continuously or for long periods of time. A Class I, Zone 1 location is a location in which ignitable concentrations of flammable gases or vapors are likely to exist because of repair or maintenance operations or because of leakage or possible release of ignitable concentrations of flammable gases or vapors, or is a location that is adjacent to a Class I, Zone 0 location from which ignitable concentrations of vapors could be communicated.

Electronic instrumentation may exist in hazardous environments which may include flammable and/or explosive substances, such as in petrochemical production facilities. Thus, in addition to the hazards of electronic instrumentation generating internal ignition, the electronic instrumentation may pose further risk to external environments.

Further, some external environments may pose additional risk to electronic instrumentation. For example, ignition sources external to the electronic instrumentation may present a risk to the electronic instrumentation. In such environments, it is desirable to prevent an ignition of flammable and/or explosive substances within the external environment (and outside of the electronic instrumentation) from entering the electronic instrumentation.

In order to comply with standards for a hazardous environment, such as ICE standard 600079, and for safety of the personnel in the field, field devices may be housed in an enclosure. Threads are integral and critical in explosion proof or resistant. An opening is needed for access to the field devices. When unused, the opening needs to be sealed with threaded covering, where the threads provide a flame pathway that allows hot gases produced by an internal explosion to cool before reaching and igniting surrounding atmosphere in the hazardous environment. Therefore, when closing the covering onto the opening, the threads need to be intact and to be engaged with corresponding threads on the opening of the enclosure. Further, the covering needs to meet the required wall thickness to withstand the pressure from explosion. For relatively large field devices included in the enclosure, the opening is relatively large for the access needed in maintenance and/or operation. Therefore, the covering may become relatively heavy and large to meet the needs for explosion management. For example, the covering may have a diameter of 13.5 inches (34.29 cm) or greater and a weight of 20 lb. (9 kg) or greater. To maneuver such a large and heavy covering while ensuring intactness and engagement of threads is challenging or even unmanageable for a field worker. In addition, due to the weight and the size of the covering, an accidental drop of the covering may injure the field worker and/or damage the covering. Further, pressure may build up inside the enclosure. The built-up pressure may launch the covering into air the moment when the cover is removed from the enclosure, causing injury to the field worker and/or damage the covering.

Explosion proof devices, cover assemblies, and methods described herein solve the above-described problems in known explosion resistant devices. The cover assembly described herein is rotatably coupled with the body of the enclosure. In the cover assembly, the cap is retained by the radial support. As a result, the cap along with the cover assembly is retained with the body when the cover assembly is open from the enclosure, reducing or eliminating accidental drop of the cap and therefore the likelihood of injury to the worker or damage to the cap. In addition, a latch and/or a joint of the cover assembly increases the strength of the cap being retained with the cover assembly and the enclosure, thereby ensuring the cap being retained with the cover assembly and the enclosure even under pressurized conditions. Retaining the cap with cover assembly and the enclosure is also advantageous in increasing the ease in installing or removal of the cap, where the radial support, instead of a worker, bears the weight of the cap. The cover assembly facilitates the alignment of the threads of the cap with the threads on the enclosure, further increasing the ease in engaging the cap onto the enclosure and reducing the likelihood of cross threading and damage to the threads caused by cross threading. The burden to lift the cover, engage the cap threads with the rim threads, and align the cap with the opening is alleviated or removed from the worker, and the safety of the equipment and the worker is increased.

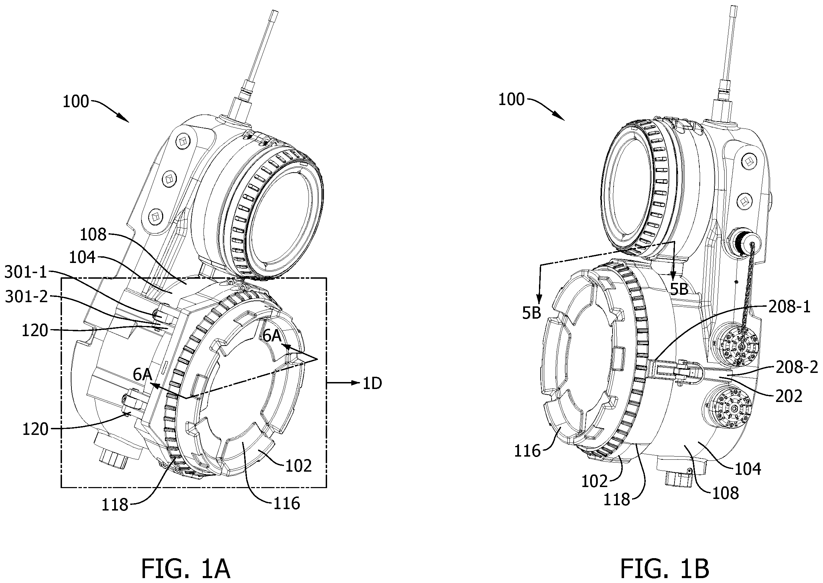

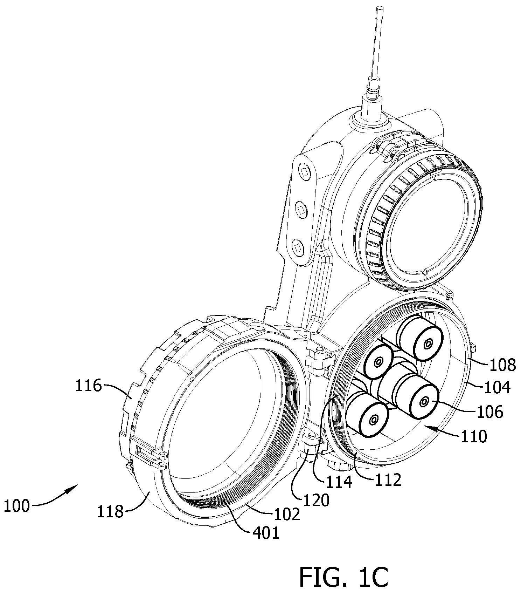

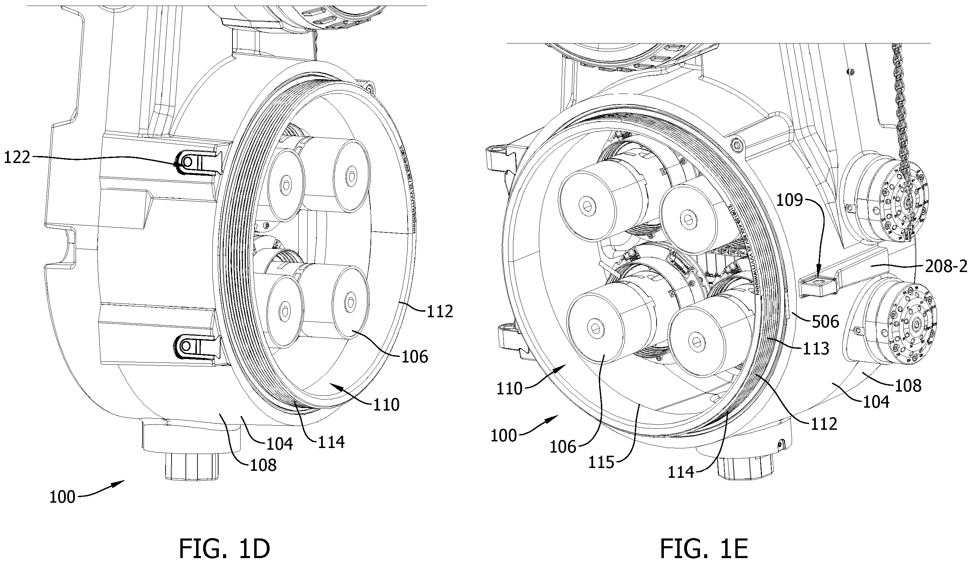

FIGs. 1A-1E show an example explosion-resistant device 100 for a hazardous environment. FIG. 1A is a left perspective view of explosion-resistant device 100. FIG. 1B is a right perspective view of explosion-resistant device 100. FIG. 1C shows explosion-resistant device 100 with a cover assembly 102 of explosion-resistant device 100 being open. FIG. 1D is a left perspective view of a portion of explosion-resistant device 100 indicated as 1D in FIG. 1A. FIG. 1E is a right perspective view of the portion.

In the example embodiment, explosion-resistant device 100 includes an enclosure 104 sized to contain equipment 106 therein. Equipment may be industrial instruments used in a hazardous environment, such as chromatographic devices. Enclosure 104 includes a body 108. Enclosure 104 further includes a projected rim 112 extending away from body 108 and defining an opening 110 that provide access to equipment 106. Enclosure 104 also includes rim threads 114 positioned on a surface of projected rim 112. In the depicted embodiment, rim threads 114 are positioned on an exterior body surface 113 of enclosure 104. In some embodiments, rim threads 114 may be positioned on an interior body surface 115 of enclosure 104.

In the example embodiment, enclosure 104 further includes cover assembly 102. Cover assembly 102 includes a cap 116 and a radial support 118. Cover assembly 102 further includes a joint 120 configured to rotatably couple cover assembly 102 with enclosure 104.

In operation, cover assembly 102 is coupled with enclosure 104 via joint 120. Cover assembly 102 may be opened from enclosure 104 or closed with enclosure 104 by swinging cover assembly 102 about joint 120, where cover assembly 102 rotates around an axis defined by joint 120.

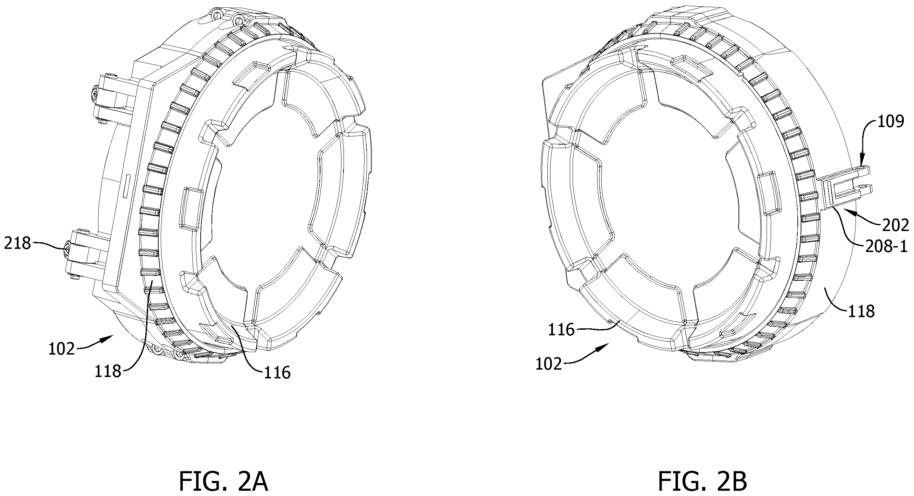

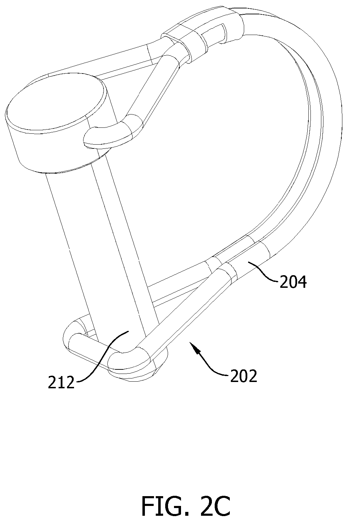

FIGs. 2A-2C show example cover assembly 102. FIG. 2A is a left perspective view of cover assembly 102. FIG. 2B is a right perspective view of cover assembly 102. FIG. 2C is a perspective view of a fastening assembly in an example latch 202 of cover assembly 102. In the example embodiment, cover assembly 102 includes cap 116, radial support 118, and joint 120. Cover assembly 102 further includes latch 202 (also see FIGs. 1B and 1E). Latch 202 includes a first latch portion 208-1 and a second latch portion 208-2 (also see FIG. 1B). In the depicted embodiment, first latch portion 208-1 is positioned on radial support 118, and second latch portion 208-2 is positioned on body 108. In some embodiments, the positioning of first latch portion 208 and second latch portion 208 may be reversed, where first latch portion 208 is positioned on body 108 and second latch portion 208 is positioned on radial support 118. First and second latch portions 208 define latch apertures 109 (FIG. 2B and also see FIG. 1E), which are sized to receive a latch pin 212 therethrough. Latch 202 further includes a loop 204. Loop 204 is couplable with latch pin 212 at ends of latch pin 212. In some embodiments, cover assembly 102 does not include a latch 202.

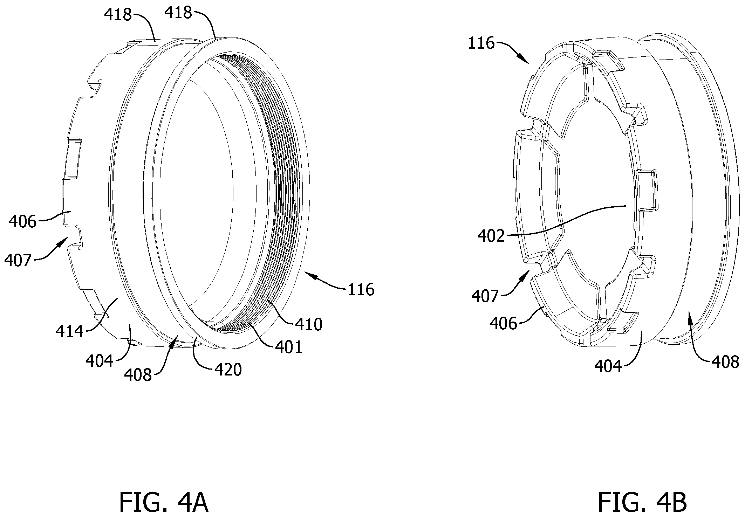

In operation, to close cover assembly 102 onto enclosure 104, cover assembly 102 is rotated to the closed positioned. Cap 116 is rotated such that cap threads 401 (see FIG. 4A described later) engage with rim threads 114 on the projected rim 112 of enclosure 104. The coupling between cover assembly 102 and enclosure 104 is strengthened by latch 202. After first latch portion 208 is positioned adjacent second latch portion 208. Latch pin 212 is inserted into latch apertures 109 defined in first and second latch portions 208, thereby holding first latch portion 208 and second latch portion 208 together. One end of loop 204 is attached to a first end of latch pin 212. The other end of loop 204 is placed onto a second end of latch pin 212 to retain latch pin 212 to be positioned in latch apertures 109 (see FIGs. 1B and 1E). In opening cover assembly 102, latch 202 may be unlatched by removing an end of loop 204 from latch 202 and then removing latch pin 212 from latch apertures 109. Unlatching of latch 202 may be performed after cap 116 has been unthreaded from projected rim 112, such that latch 202 continues to hold radial support 118 and cap 116 with body 108, even when enclosure 104 is pressurized, thereby increasing the safety of the worker and intactness of cap 116 by preventing cap 116 from flying outwards due to the pressure.

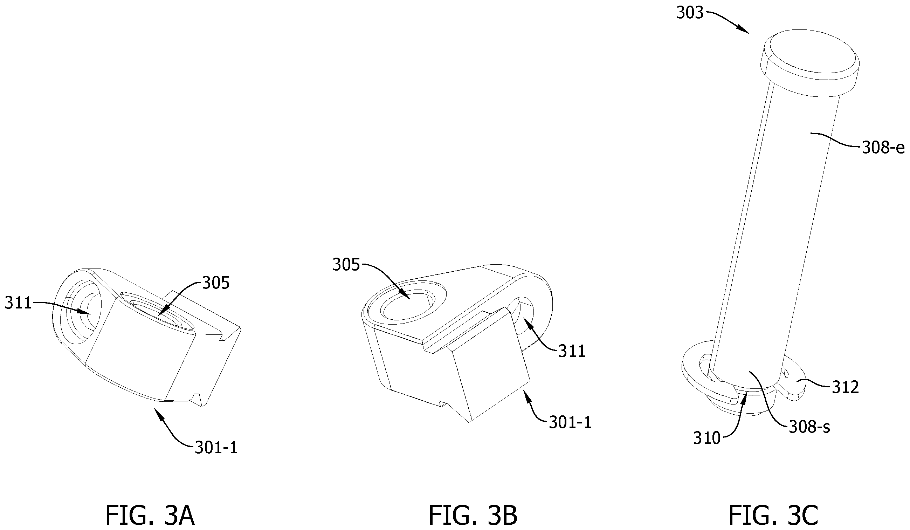

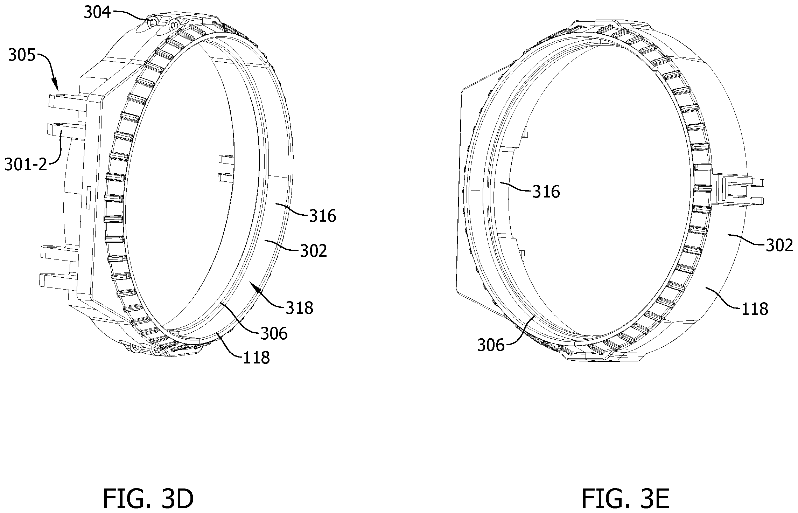

FIGs. 3A-3E show example joint 120. FIG. 3A is a front perspective view of a first joint portion 301 of joint 120. FIG. 3B is a rear perspective view of first joint portion 301. FIG. 3C is a perspective view of a joint pin 303 of joint 120. FIG. 3D is a left perspective view of radial support 118 and a second joint portion 301 of joint 120. FIG. 3E is a right perspective view of radial support 118 and second joint portion 301.

In the example embodiment, joint 120 includes first joint portion 301-1 and second joint portion 301-2 (also see FIG. 1A). Joint apertures 305 are defined in first joint portion 301 and second joint portion 301. First joint portion 301 further defines a fastener aperture 311 sized to receive a fastener 218 (see FIG. 2A) therethrough. Joint 120 further includes joint pin 303. Joint pin 303 may include an enlarged end 308-e and a second end 308-s opposite enlarged end 308-e. Second end 308 defines a groove 310. Joint pin 303 further includes a stopper 312. In the depicted example, stopper 312 forms into a ring or an arc. Ends of stopper 312 are received in groove 310 when stopper 312 is coupled with joint pin 303.

In operation, joint 120 is assembled onto body 108 by coupling first joint portion 301-1 with second joint portion 301-2 such that joint apertures 305 are aligned. Joint pin 303 is inserted into joint apertures 305 and stopper 312 is placed into groove 310. Second joint portion 301 may be formed integral with radial support 118 or support segment 302 (see FIG. 3D), via methods such as casting and machining. Alternatively, second joint portion 301 may be coupled with radial support 118 or support segment 302 via methods such as welding. The cover assembly 102 assembled joint 120 is fastened to body 108 of enclosure 104 by inserting fastener 218 into fastener apertures 305 and a corresponding faster aperture 122 (see FIG. 1D) defined in body 108 and fastening cover assembly 102 with body 108 via fastener 218. Example fastener 218 may be a screw.

A cover assembly 102 with a joint 120 positioned on the left side and a latch 202 positioned on the right side of the enclosure is depicted for illustration purposes only. Joint 120 may be positioned on the right side such that cover assembly 102 opens and swings toward right. A cover assembly 102 may include a plurality of latches 202 distributed around projected rim 112.

Referring to FIGs. 3D and 3E, in the example embodiment, cover assembly 102 includes radial support 118. In the depicted example, radial support 118 includes two support segments 302. Support fasteners 304 joins support segments 302. In some embodiments, radial support 118 may be in one single piece or may be in three or more segments with support fasteners 304 joining support segments 302. The diameter of radial support 118 may be adjusted when radial support 118 is formed with multiple support segments 302. Radial support 118 may form into an annular ring. Radial support 118 further includes a support projection 306 projecting from an interior surface 316 of radial support 302. Support projection 306 is formed as an annular raised ring. Support projection 306 defines support recesses 318 in radial support 118 adjacent support projection 306.

FIGs. 4A and 4B show cap 116 of cover assembly 102. FIG. 4A is a rear perspective view of cap 116. FIG. 4B is a right perspective view of cap 116. In the example embodiment, cap 116 includes cap threads 401. Cap 116 includes a cap top 402 and a cap side 404 extending from cap top 402. Cap side 404 is annular. Cap top 402 may include ridges 406 and define top recesses 407 between neighboring ridges 406. Top recesses 407 are shaped to receive a tool to facilitate the turning of cap 116. In the depicted example, cap threads 401 are positioned on an interior side surface 410 of cap side 404 and rim threads 114 are positioned on exterior body surface 113 (see FIG. 1E) of body 108 such that cap threads 401 are female threads and rim threads 114 are male threads. In some embodiments, positioning of cap threads 401 and rim threads 114 is reversed, where cap threads 401 are positioned on an exterior side surface 414 of cap side 404 and rim threads 114 are positioned on interior body surface 115 of body 108. Cap side 404 further include a side projection 418. Side projection 418 may be positioned adjacent to an end 420 of cap side 404 opposite from cap top 402. Cap side 404 may include a plurality side projections 418. A side recess 408 is defined on exterior side surface 414 of cap side 404. Side recess 408 may be continuous and form into a ring. Side recess 408 may be positioned on cap side 404 with two side projections 418 bordering side recess 408.

In the example embodiment, cap 116 may be fabricated from metal such as aluminum or steel. Cap 116 may be manufactured by methods such as casting, machining, or stamping.

In operation, to assemble cap 116 with radial support 118, cap 116 is positioned with support segments 302 such that side projection 418 is received in support recess 318 and support projection 306 is received in side recess 408. Support segments 302 are coupled together by support fasteners 304.

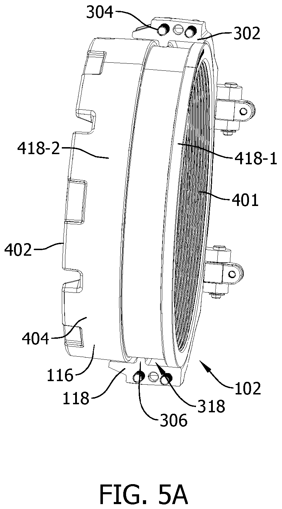

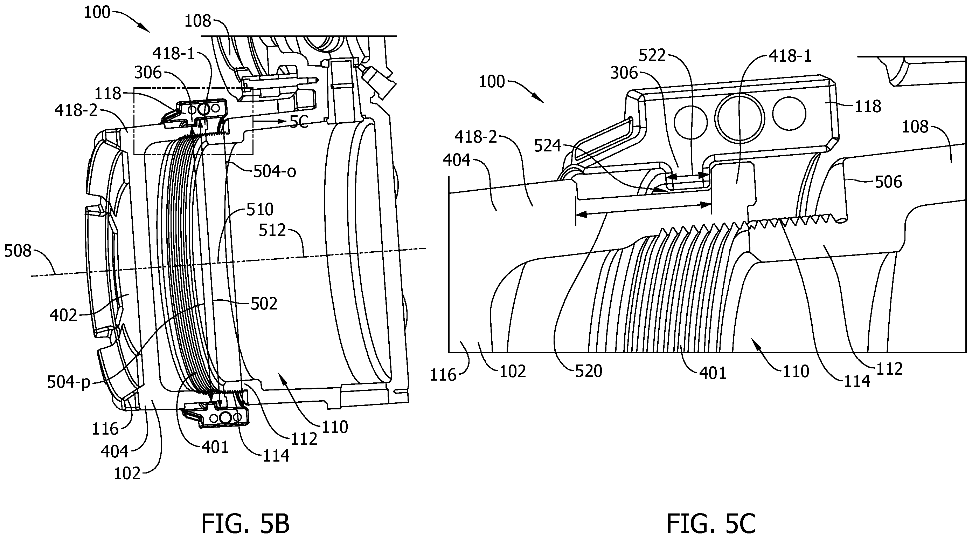

FIGs. 5A-5C show radial support 118 being coupled with cap 116. FIG. 5A is a side view of cover assembly 102 with one of support segments 302 removed. FIG. 5B is a portion of a cross-sectional view of explosion-resistant device 100 along cross-sectional line 5B-5B as indicated in FIG. 1B. FIG. 5C is an enlarged view of a portion of explosion-resistant device 100, where the portion is indicated as 5C in FIG. 5B.

In the example embodiment, outer diameter 502 of cap side 404 at side projection 418 is greater than inner diameter 504-p of radial support 118 at support projection 306 and smaller than inner diameter 504-o of radial support 118 at some of other interior locations of radial support 118. As such, with a side projection 418 positioned further interior than support projection 306, support projection 306 obstructs cap 116 from dislocating from radial support 118 when a force, such as a force from pressure inside enclosure 104, is applied in the direction of being outwards from body 108. Cap side 404 may include a second side projection 418-2 bordering side recess 408 and being at a side opposite first side projection 418-1 such that support projection 306 is received in side recess 408 and positioned between first side projection 418-1 and second side projection 418-2. Second side projection 418 prevents cap 116 from being rotated too far toward body 108 in threading cap 116 onto projected rim 112. In the depicted embodiment, body 108 includes a ledge 506 (FIG. 5C, also see FIG. 1E). Ledge 506 prevents cap 116 from being rotated too far toward body 108. In some embodiments, body 108 does not include ledge 506.

In the example embodiment, inner diameter 504-p of radial support 118 at support projection 306 is smaller than outer diameter 502 of cap side 404 at first side projection 418 and second side projection 418. Accordingly, radial support 118 obstructs cap 116 from dislocating out of radial support 118 from either end of cap side 404, and vice versa, cap 116 also obstructs radial support 118 from dislocating out of cap 116.

In the example embodiment, side recess 408 may be formed as an annular recess. The annular raised ring formed by support projection 306 and the annular recess formed by side recess 408 may be concentric such that a longitudinal axis 508 of cap side 404 and a longitudinal axis 510 of radial support 118 are aligned. A width 520 of side recess is greater than a width 522 of support projection 306. Translational movement of cap 116 is limited to moving in the range of width 520 of side recess 408.

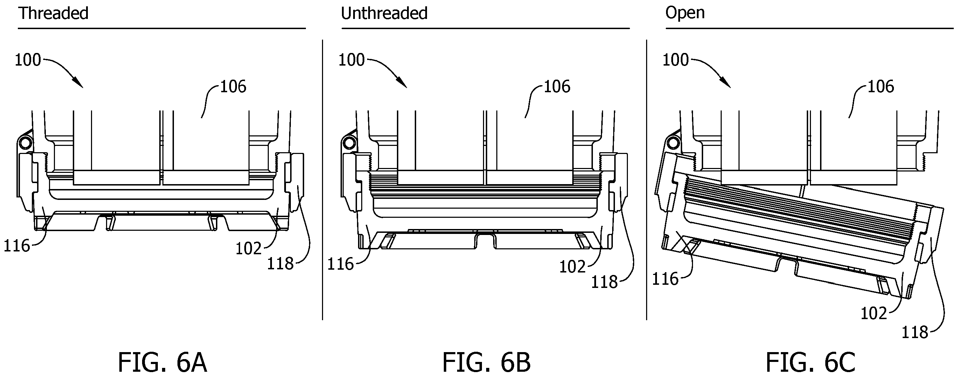

FIGs. 6A-6C show cover assembly 102 at various positions. FIG. 6A shows the threaded position where cap 116 is threaded onto projected rims 112. FIG. 6B shows the unthread position, where cap 116 is unthreaded from projected rims 112. FIG. 6C shows an open position, where cover assembly 102 is open from body 108.

In the example embodiment, when cap 116 is unthreaded from projected rim 112 or cover assembly 102 is open, cap 116 is retained with radial support 118, thereby eliminating or reducing the likelihood that cap 116 falls and causes injury to a worker or damage to cap 116. To thread cap 116 onto body 108, cover assembly 102 is swung back to face projected rim 112.

Referring back to FIGs. 5B and 5C, in the example embodiment, cover assembly 102 is advantageous in increasing the ease in threading cap 116 onto projected rims 112. When cover assembly 102 is coupled with enclosure 104, first joint portion 301 of joint 120 affixes radial support 118 with body 108 at one side and latch(es) 202 may attach radial support 118 at the other side. Radial support 118 is positioned around projected rim 112. Positions of joint 120 and latch(es) 202 on body 108 may be adjusted such that longitudinal axis 510 of radial support 118, along with longitudinal axis 508 of cap side 404, aligns with longitudinal axis 512 of projected rim 112. When cap 116 is assembled with radial support 118, longitudinal axis 510 of radial support 118 and longitudinal axis 508 of cap side 404 are aligned (see FIG. 5B). When radial support is place on projected rim 112. the aligned longitudinal axes 510, 512 is also aligned with longitudinal axis 512 of projected rim 112. With the axes aligned, cap threads 401 engage with rim threads 114 with an increased ease, thereby reducing the likelihood of damaging cap threads 401 and/or rim threads 114 from cross threading.

In the example embodiment, a gap 524 is provided between support projection 306 and cap side 404. The width of gap 524 is selected to balance the need to provide space for the axial movement of cap 116 and the need to limit radial movement of cap 116 in aligning and engaging threads 114, 401. Gap 524 provides space for the axial movement of cap 116 without cap side 404 scraping radial support 118. In the meantime, gap 524 is selected for the self-alignment of cap threads 401 and rim threads 114, where gap 524 is relatively small to limit the radial movement of cap 116. In some embodiments, a lubricant (not shown) such as a lubricative material or a lubricating coating may be applied on the surface of support projection 306 and/or the surface of cap side 404 to reduce the friction between the surfaces.

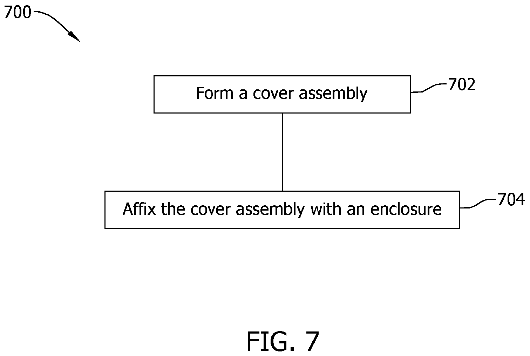

FIG. 7 is a flow chart of an example method 700 of assembling an explosion-resistant device for a hazardous environment. In the example embodiment, method 700 includes forming 702 a cover assembly. Example cover assemblies are cover assemblies 102 described herein. Method 700 also includes affixing 704 the cover assembly with an enclosure of an explosion-resistant device.

At least one technical effect of the assemblies, systems, and methods described herein includes (a) a cover assembly with a cap retained by a radial support; (b) a cover assembly rotatably coupled with an enclosure of an explosion-resistant device via a joint; (c) self-alignment of threads by the cover assembly; and (d) a latch in a cover assembly that increases the strength of the cover being retained with the enclosure.

Example embodiments of explosion resistant devices, assemblies, and methods are described above in detail. The systems and methods are not limited to the specific embodiments described herein but, rather, components of the systems and/or operations of the methods may be utilized independently and separately from other components and/or operations described herein. Further, the described components and/or operations may also be defined in, or used in combination with, other systems, methods, and/or devices, and are not limited to practice with only the systems described herein.

As used herein, an element or step recited in the singular and proceeded with the word "a" or "an" should be understood as not excluding plural elements or steps, unless such exclusion is explicitly recited. Furthermore, references to "example" or "one example" of the present disclosure are not intended to be interpreted as excluding the existence of additional examples that also incorporate the recited features. Further, to the extent that terms "includes," "including," "has," "contains," and variants thereof are used herein, such terms are intended to be inclusive in a manner similar to the term "comprises" as an open transition word without precluding any additional or other elements.

Although specific features of various embodiments of the invention may be shown in some drawings and not in others, this is for convenience only. In accordance with the principles of the invention, any feature of a drawing may be referenced and/or claimed in combination with any feature of any other drawing.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. An explosion-resistant device for a hazardous environment, comprising:
an enclosure sized to enclose equipment therein and comprising a body, the enclosure further comprising:
a projected rim extending away from the body and defining an opening, the opening providing an access to the equipment; and
rim threads positioned on a surface of the projected rim; and
a cover assembly comprising:
a joint comprising a first portion and a second portion, the first portion affixed with the body;
a cap comprising:
a cap top; and
a cap side extending from the cap top, the cap side further comprising cap threads complementary to the rim threads; and
a radial support affixed with the second portion and obstructing the cap from dislocating out of the radial support,
wherein the cover assembly is rotatably coupled with the enclosure via the joint.

2. The explosion-resistant device of claim 1, wherein the radial support comprises a support projection projecting from an interior surface of the radial support, the cap side further comprising a side projection positioned adjacent to an end of the cap side opposite from the cap top, the side projection projecting from an exterior side surface of the cap side, the support projection positioned between the cap top and the side projection and obstructing the cap from dislocating out of the radial support,
wherein preferably: the support projection comprises an annular raised ring, the cap side defining a side recess, the annular raised ring being concentric to the side recess and received in the side recess.

3. The explosion-resistant device of claim 1 or 2, wherein the cover assembly further comprises a latch configured to removably couple the radial support with the body.

4. The explosion-resistant device of any one of the preceding claims, wherein the cap side comprises a first side projection and a second side projection and defines a side recess positioned between the first side projection and the second side projection,
wherein the radial support preferably comprises an annular raised ring concentric to the side recess, an outer diameter of the cap side at the side recess being smaller than an inner diameter of the radial support at the annular raised ring.

5. The explosion-resistant device of any one of the preceding claims, wherein the radial support comprises a first support segment, a second support segment, and one or more support fasteners joining the first support segment with the second support segment.

6. The explosion-resistant device of any one of the preceding claims, further comprising a lubricant applied to the radial support and/or the cap side.

7. A cover assembly of an explosion-resistant device for a hazardous environment, comprising:
a joint comprising a first portion and a second portion, the first portion configured to be affixed with an enclosure of an explosion-resistant device;
a radial support affixed with the second portion; and
a cap comprising:
a cap top; and
a cap side extending from the cap top,
wherein the radial support comprises a support projection projecting from an interior surface of the radial support, the cap side further comprising a side projection positioned adjacent to an end of the cap side opposite from the cap top, the side projection projecting from an exterior side surface of the cap side, the support projection positioned between the cap top and the side projection and obstructing the cap from dislocating out of the radial support, and
wherein the cover assembly is configured to rotatably couple with the enclosure via the joint.

8. The cover assembly of claim 7, wherein the support projection comprises an annular raised ring, the cap side defining a side recess, the annular raised ring being concentric to the side recess and received in the side recess.

9. The cover assembly of claim 7 or 8, wherein the cover assembly further comprises a latch configured to removably couple the radial support with the enclosure.

10. The cover assembly of any one of the claims 7 to 9, wherein the cap side comprises a first side projection and a second side projection and defines a side recess positioned between the first side projection and the second side projection,
wherein the radial support preferably comprises an annular raised ring concentric to the side recess, an outer diameter of the cap side at the side recess being smaller than an inner diameter of the radial support at the annular raised ring.

11. The cover assembly of any one of the claims 7 to 10, wherein the radial support comprises a first support segment, a second support segment, and one or more fasteners joining the first support segment with the second support segment.

12. The cover assembly of any one of the claims 7 to 11, further comprising a lubricant applied to the radial support and/or the cap side.

13. A method of assembling an explosion-resistant device for a hazardous environment, the method comprising:
forming a cover assembly, wherein the cover assembly includes:
a joint including a first portion and a second portion;
a cap including:
a cap top; and
a cap side extending from the cap top, the cap side further including cap threads; and
a radial support affixed with the second portion and obstructing the cap from dislocating out of the radial support;
affixing the cover assembly with an enclosure of an explosion resistant device, the enclosure sized to contain equipment therein and including a body, the enclosure further including:
a projected rim extending away from the body and defining an opening providing an access to the equipment; and
rim threads positioned on a surface of the projected rim and complementary to the cap threads,
wherein affixing the cover assembly further comprises affixing the first portion of the joint with the body.

14. The method of claim 13, wherein forming the cover assembly further comprises at least one of the following (a) to (c):
(a) selecting a gap between the cap side and the radial support to facilitate self-alignment of the cap side with the projected rim;
(b) positioning a side projection of the cap side adjacent to a support projection of the radial support such that the support projection obstructs the cap from dislocating out of the radial support; and
assembling the radial support by joining a first support segment with a second support segment via one or more fasteners;
(c) the radial support includes an annular raised ring, the cap side defining a side recess, and forming the cover assembly further comprises positioning the annular raised ring in the side recess.

15. The method of claim 13 or 14, wherein the cover assembly further includes a latch configured to removably couple the radial support with the body.
